# EUROPEAN PATENT SPECIFICATION

(11) **EP 1 680 713 B1**
(45) Date of publication and mention of the grant of the patent: **23.09.2015**
(21) Application number: 04800170.5
(22) Date of filing: 05.11.2004
(51) Int. Cl.: G03F 7/038, G03F 7/004, B29C 67/00, G03F 7/00

(54) **CURABLE COMPOSITIONS AND RAPID PROTOTYPING PROCESS USING THE SAME**
AUSHÄRTBARE ZUSAMMENSETZUNGEN UND DIESE VERWENDENDER SCHNELLER PROTOTYP-ERZEUGUNGSPROZESS
COMPOSITIONS DURCISSABLES ET PROCEDE DE PROTOTYPAGE RAPIDE L'UTILISANT

(30) Priority: 06.11.2003 US 517407 P; 02.12.2003 US 526151 P
(43) Date of publication of application: 19.07.2006
(73) Proprietor: DSM IP Assets B.V., 6411 TE Heerlen (NL)
(72) Inventor: YOU, Xiaorong, Elgin, Illinois 60120-8498 (US); XU, Jigeng, Elgin, Illinois 60120-8498 (US)
(74) Representative: Hatzmann, Martin
(86) International application number: PCT/NL2004/000778
(87) International publication number: WO 2005/045525

(56) References cited:
- EP-A- 0 360 869
- EP-A- 0 848 292
- EP-A- 1 437 624
- EP-A- 1 508 834
- WO-A-97/38354
- WO-A-99/05571
- WO-A-03/093901
- DE-A- 10 150 256
- US-A1- 2004 023 145
- US-B1- 6 413 696
- US-B1- 6 413 697
- "LASER-CURABLE FORMULATION FOR THE PRODUCTION OF FUNCTIONAL MODEL PARTS FROM STEREO LITHOGRAPHY" IBM TECHNICAL DISCLOSURE BULLETIN, IBM CORP. NEW YORK, US, vol. 32, no. 8B, January 1990 (1990-01), pages 23-24, XP000082448 ISSN: 0018-8689
- MARUO S ET AL: "Submicron stereolithography for the production of freely movable mechanisms by using single-photon polymerization" SENSORS AND ACTUATORS A, ELSEVIER SEQUOIA S.A., LAUSANNE, CH, vol. 100, no. 1, 15 August 2002 (2002-08-15), pages 70-76, XP004373763 ISSN: 0924-4247

## Description

### FIELD OF THE INVENTION

The present invention relates to curable compositions capable of providing articles having a good elongation at break, and excellent tensile strength or Young's modulus. In addition the present invention relates to applications for such compositions, such as their use in rapid prototyping processes.

### BACKGROUND

In the field of curable compositions, for instance in the field of rapid prototyping compositions, high tensile strength and /or high Young's Modulus at good elongation to break are relevant parameters. Unfortunately, a composition providing good tensile strength or Young's modulus often exhibits a poor elongation to break. One of the objectives of the present invention is to provide compositions yielding both a good tensile strength or good Young's modulus and a good elongation to break.

Examples of prior curable compositions are set forth in, for instance, U.S. Patent 5,476,748; U.S. Patent 5,707,780; U.S. Patent 5,972,563; European Patent Application 0831373 and US 6,013,714.

### SUMMARY

The present invention provides compositions having a high tensile strength or high Young's modulus and a good elongation at break.

The invention concerns a composition according to claim 1 and a rapid prototyping process according to claim 12. The features are defined in the claims.

Additional objects, advantages and features of the present invention are set forth in this specification, and in part will become apparent to those skilled in the art on examination of the following, or may be learned by practice of the invention.

### DETAILED DESCRIPTION

### (A) Cationicaly polymerizable compound

The present compositions comprise at least one cationically curable component, *e.g.* at least one cyclic ether component, cyclic lactone component, cyclic acetal component, cyclic thioether component, spiro orthoester component, epoxy-functional component, and/or oxetane-functional component. Preferably, the present compositions comprise at least one component selected from the group consisting of epoxy-functional components and oxetane-functional components. Preferably, the compositions comprise, relative to the total weight of the composition, at least 20 wt% of cationically curable components, preferably at least 40 wt%, or at least 50 wt%. Generally, the compositions comprise, relative to the total weight of the composition, less than 95 wt% of cationically curable components, for instance less than 90 wt%, less than 80 wt%, or less than 70 wt%.

The amounts of components are expressed as weight % of component relative to the total weight of the composition, unless explicitly stated otherwise.

### (A1) Epoxy-functional components

The present compositions preferably comprise epoxy-functional components, an aromatic epoxy-functional component ("aromatic epoxy") and an aliphatic epoxy-functional component ("aliphatic epoxy"). Epoxy-functional components are components comprising one or more epoxy groups, *i*.*e*. one or more three-member ring structures (oxiranes) according to formula (1):

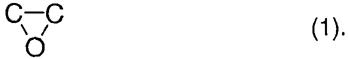

### (A 1-i) aromatic epoxies

Aromatic epoxies are components that comprise one or more epoxy groups and one or more aromatic rings. The compositions may comprise one or more aromatic epoxies.

Examples of aromatic epoxies include aromatic epoxies derived from a polyphenol, *e.g.* from bisphenols such as bisphenol A (4,4'-isopropylidenediphenol), bisphenol F (bis[4-hydroxyphenyl]methane), bisphenol S (4,4'-sulfonyldiphenol), 4,4'-cyclohexylidenebisphenol, 4,4'-biphenol, or 4,4'-(9-fluorenylidene)diphenol. The bisphenols may be alkoxylated (*e*.*g*. ethoxylated and/or propoxylated) and/or halogenated (*e*.*g*. brominated). Examples of bisphenol epoxies include bisphenol diglycidyl ethers.

Further examples of aromatic epoxies include triphenylolmethane triglycidyl ether, 1,1,1-tris(p-hydroxyphenyl)ethane triglycidyl ether, and aromatic epoxies derived from a monophenol, *e*.*g*. from resorcinol (for instance resorcin diglycidyl ether) or hydroquinone (for instance hydroquinone diglycidyl ether). Another example is nonylphenyl glycidyl ether.

In addition, examples of aromatic epoxies include epoxy novolacs, for instance phenol epoxy novolacs and cresol epoxy novolacs. Commercial examples of cresol epoxy novolacs include, *e*.*g*., EPICLON N-660, N-665, N-667, N-670, N-673, N-680, N-690, and N-695, manufactured by Dainippon Ink and Chemicals, Inc. Examples of phenol epoxy novolacs include, *e*.*g*., EPICLON N-740, N-770, N-775, and N-865, manufactured by Dainippon Ink and Chemicals Inc.

In one embodiment of the invention, the present compositions may comprise, relative to the total weight of the composition, at least 10wt% of one or more aromatic epoxies.

### (A1-ii) aliphatic epoxies

Aliphatic epoxies are components that comprise one or more epoxy groups and are absent an aromatic ring. The compositions may comprise one or more aliphatic epoxies.

Examples of aliphatic epoxies include glycidyl ethers of C₂-C₃₀ alkyls; 1,2 epoxies of C₃-C₃₀ alkyls; mono and multi glycidyl ethers of aliphatic alcohols and polyols such as 1,4-butanediol, neopentyl glycol, cyclohexane dimethanol, dibromo neopentyl glycol, trimethylol propane, polytetramethylene oxide, polyethylene oxide, polypropylene oxide, glycerol, and alkoxylated aliphatic alcohols and polyols.

In one embodiment, it is preferred that the aliphatic epoxies comprise one or more cycloaliphatic ring structures. For instance, the aliphatic epoxies may have one or more cyclohexene oxide structures, *e*.*g*. two cyclohexene oxide structures. Examples of aliphatic epoxies comprising a ring structure include hydrogenated bisphenol A diglycidyl ethers, hydrogenated bisphenol F diglycidyl ethers, hydrogenated bisphenol S diglycidyl ethers, bis(4-hydroxycyclohexyl)methane diglycidyl ether, 2,2-bis(4-hydroxycyclohexyl)propane diglycidyl ether, 3,4-epoxycyclohexylmethyl-3,4-epoxycyclohexanecarboxylate, 3,4-epoxy-6-methylcyclohexylmethyl-3,4-epoxy-6-methylcyclohexanecarboxylate, di(3,4-epoxycyclohexylmethyl)hexanedioate, di(3,4-epoxy-6-methylcyclohexylmethyl)hexanedioate, ethylenebis(3,4-epoxycyclohexanecarboxylate), ethanedioldi(3,4-epoxycyclohexylmethyl) ether, and 2-(3,4-epoxycyclohexyl-5,5-spiro-3,4-epoxy)cyclohexane-1,3-dioxane.

Examples of aliphatic epoxies are also listed in U.S. Patent 6,410,127.

The present compositions comprise, relative to the total weight of the composition, at least 20 wt% of one or more aliphatic epoxies. Generally, the present compositions will comprise, relative to the total weight of the composition, less than 70 wt% of aliphatic epoxies, for instance less than 50 wt%, less than 40 wt%.

Preferably the composition of the present invention comprises one or more mono or poly glycidylethers of aliphatic alcohols, aliphatic polyols, polyesterpolyols or polyetherpolyols. Examples of preferred components include 1,4-butanedioldiglycidylether, glycidylethers of polyoxyethylene and polyoxypropylene glycols and triols of molecular weights from about 200 to about 10,000; glycidylethers of polytetramethylene glycol or poly(oxyethylene-oxybutylene) random or block copolymers.

Examples of commercially available preferred glycidylethers are: polyfunctional glycidylethers: Heloxy 48, Heloxy 67, Heloxy 68, Heloxy 107, Grilonit F713; monofunctional glycidylethers Heloxy 71, Heloxy 505, Heloxy 7, Heloxy 8, Heloxy 61.

The composition of the present invention preferably contains between 3 and 40, more preferably between 5 and 20 wt% of mono or poly glycidyl ethers of an aliphatic alcohol, aliphatic polyols, polyesterpolyol or polyetherpolyol.

### (A2) Oxetane-functional components

The present compositions may comprise one or more oxetane-functional components ("oxetanes"). Oxetanes are components comprising one or more oxetane groups, *i*.*e*. one or more four-member ring structures according to formula (5):

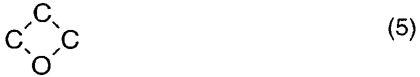

Examples of oxetanes include components represented by the following formula (6): 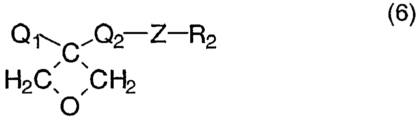 wherein
Q₁ represents a hydrogen atom, an alkyl group having 1 to 6 carbon atoms (such as a methyl, ethyl, propyl, or butyl group), a fluoroalkyl group having 1 to 6 carbon atoms, an allyl group, an aryl group, a furyl group, or a thienyl group;
Q₂ represents an alkylene group having 1 to 6 carbon atoms (such as a methylene, ethylene, propylene, or butylene group), or an alkylene group containing an ether linkage, for example, an oxyalkylene group, such as an oxyethylene, oxypropylene, or oxybutylene group
Z represents an oxygen atom or a sulphur atom; and
R₂ represents a hydrogen atom, an alkyl group having 1-6 carbon atoms (e.g. a methyl group, ethyl group, propyl group, or butyl group), an alkenyl group having 2-6 carbon atoms (e.g. a 1-propenyl group, 2-propenyl group, 2-methyl-1-propenyl group, 2-methyl-2-propenyl group, 1-butenyl group, 2-butenyl group, or 3-butenyl group), an aryl group having 6-18 carbon atoms (e.g. a phenyl group, naphthyl group, anthranyl group, or phenanthryl group), a substituted or unsubstituted aralkyl group having 7-18 carbon atoms (e.g. a benzyl group, fluorobenzyl group, methoxy benzyl group, phenethyl group, styryl group, cynnamyl group, ethoxybenzyl group), an aryloxyalkyl group (e.g. a phenoxymethyl group or phenoxyethyl group), an alkylcarbonyl group having 2-6 carbon atoms (e.g. an ethylcarbonyl group, propylcarbonyl group, or butylcarbonyl group), an alkoxy carbonyl group having 2-6 carbon atoms (e.g. an ethoxycarbonyl group, propoxycarbonyl group, or butoxycarbonyl group), an N-alkylcarbamoyl group having 2-6 carbon atoms (e.g. an ethylcarbamoyl group, propylcarbamoyl group, butylcarbamoyl group, or pentylcarbamoyl group), or a polyethergroup having 2-1000 carbon atoms.

### (B) Cationic photoinitiators

The present compositions comprise one or more cationic photoinitiators, *i*.*e*. photoinitiators that, upon exposure to actinic radiation, form cations that can initiate the reactions of cationically polymerizable components, such as epoxies or oxetanes.

Examples of cationic photoinitiators include, for instance, onium salts with anions of weak nucleophilicity. Examples include halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Patents 3,708,296 and 5,002,856. Other examples of cationic photoinitiators include metallocene salts, such as described, for instance, in published European applications EP 94914 and 94915, which applications are both hereby incorporated in their entirety by reference.

In one embodiment, the present compositions comprise one or more photoinitiators represented by the following formula (7) or (8): 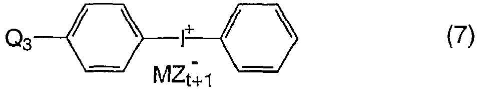 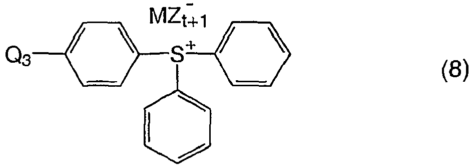 wherein
Q₃ represents a hydrogen atom, an alkyl group having 1 to 18 carbon atoms, or an alkoxyl group having 1 to 18 carbon atoms;
M represents a metal atom, *e*.*g*. antimony;
Z represents a halogen atom, *e*.*g*. fluorine; and
t is the valent number of the metal, *e*.*g*. 5 in the case of antimony.

In one embodiment, the present compositions comprise, relative to the total weight of the composition, 0.1-15 wt% of one or more cationic photoinitiators, for instance 1-10 wt%.

### (C) Free radical polymerizable components

In addition to one or more cationically curable components, the present invention preferably comprises one or more free radical curable components, *e*.*g*. one or more free radical polymerizable components having one or more ethylenically unsaturated groups, such as (meth)acrylate (*i*.*e*. acrylate and/or methacrylate) functional components.

Examples of monofunctional ethylenically unsaturated components include acrylamide, N,N-dimethylacrylamide, (meth)acryloylmorpholine, 7-amino-3,7-dimethyloctyl (meth)acrylate, isobutoxymethyl(meth)acrylamide, isobornyloxyethyl (meth)acrylate, isobornyl (meth)acrylate, 2-ethylhexyl (meth)acrylate, ethyldiethylene glycol (meth)acrylate, t-octyl (meth)acrylamide, diacetone (meth)acrylamide, dimethylaminoethyl (meth)acrylate, diethylaminoethyl (meth)acrylate, lauryl (meth)acrylate, dicyclopentadiene (meth)acrylate, dicyclopentenyloxyethyl (meth)acrylate, dicyclopentenyl (meth)acrylate, N,N-dimethyl(meth)acrylamidetetrachlorophenyl (meth)acrylate, 2-tetrachlorophenoxyethyl (meth)acrylate, tetrahydrofurfuryl (meth)acrylate, tetrabromophenyl (meth)acrylate, 2-tetrabromophenoxyethyl (meth)acrylate, 2-trichlorophenoxyethyl (meth)acrylate, tribromophenyl (meth)acrylate, 2-tribromophenoxyethyl (meth)acrylate, 2-hydroxyethyl (meth)acrylate, 2-hydroxypropyl (meth)acrylate, vinylcaprolactam, N-vinylpyrrolidone, phenoxyethyl (meth)acrylate, butoxyethyl (meth)acrylate, pentachlorophenyl (meth)acrylate, pentabromophenyl (meth)acrylate, polyethylene glycol mono(meth)acrylate, polypropylene glycol mono(meth)acrylate, bornyl (meth)acrylate, and, methyltriethylene diglycol (meth)acrylate.

Examples of the polyfunctional ethylenically unsaturated components include ethylene glycol di(meth)acrylate, dicyclopentenyl di(meth)acrylate, triethylene glycol diacrylate, tetraethylene glycol di(meth)acrylate, tricyclodecanediyldimethylene di(meth)acrylate, trimethylolpropane tri(meth)acrylate, ethoxylated trimethylolpropane tri(meth)acrylate, propoxylated trimethylolpropane tri(meth)acrylate, tripropylene glycol di(meth)acrylate, neopentyl glycol di(meth)acrylate, both-terminal (meth)acrylic acid adduct of bisphenol A diglycidyl ether, 1,4-butanediol di(meth)acrylate, 1,6-hexanediol di(meth)acrylate, polyethylene glycol di(meth)acrylate, (meth)acrylate-functional pentaerythritol derivatives (e.g. pentaerythritol tri(meth)acrylate, pentaerythritol tetra(meth)acrylate, dipentaerythritol hexa(meth)acrylate, dipentaerythritol penta(meth)acrylate, or dipentaerythritol tetra(meth)acrylate), ditrimethylolpropane tetra(meth)acrylate, ethoxylated bisphenol A di(meth)acrylate, propoxylated bisphenol A di(meth)acrylate, ethoxylated hydrogenated bisphenol A di(meth)acrylate, propoxylated -modified hydrogenated bisphenol A di(meth)acrylate, and ethoxylated bisphenol F di(meth)acrylate.

In one embodiment, the present compositions comprise one or more components having at least 3 (meth)acrylate groups, for instance 3-6 (meth)acrylate groups or 5-6 (meth)acrylate groups.

If present, the compositions may comprise, relative to the total weight of the composition, 1 % or more of one or more free radical polymerizable components, for instance at least 3 wt%, 5 wt% or at least 9 wt%. Generally, the compositions comprise, relative to the total weight of the composition, less than 50 wt% of free radical polymerizable components, for instance less than 35 wt%, less than 25 wt%, less than 20 wt%, or less than 15 wt%.

### (D) Free radical photoinitiators

The compositions may employ one or more free radical photoinitiators. Examples of free radical photoinitiators include benzophenones (*e*.*g*. benzophenone, alkyl-substituted benzophenone, or alkoxy-subsituted benzophenone); benzoins, *e*.*g*. benzoin, benzoin ethers, such as benzoin methyl ether, benzoin ethyl ether, and benzoin isopropyl ether, benzoin phenyl ether, and benzoin acetate; acetophenones, such as acetophenone, 2,2-dimethoxyacetophenone, 4-(phenylthio)acetophenone, and 1,1-dichloroacetophenone; benzil, benzil ketals, such as benzil dimethyl ketal, and benzil diethyl ketal; anthraquinones, such as 2-methylanthraquinone, 2-ethylanthraquinone, 2-tertbutylanthraquinone, 1-chloroanthraquinone, and 2-amylanthraquinone; triphenylphosphine; benzoylphosphine oxides, such as, for example, 2,4,6-trimethylbenzoyldiphenylphosphine oxide; thioxanthones and xanthones, acridine derivatives, phenazene derivatives, quinoxaline derivatives or I-phenyl-1,2-propanedione-2-O-benzoyloxime, I-aminophenyl ketones or I-hydroxyphenyl ketones, such as I-hydroxycyclohexyl phenyl ketone, phenyl (1-hydroxyisopropyl)ketone and 4-isopropylphenyl(1-hydroxyisopropyl)ketone, or triazine compounds, for example, 4"'-methyl thiophenyl-1-di(trichloromethyl)-3,5-S-triazine, S-triazine-2-(stilbene)-4,6-bistrichloromethyl, and paramethoxy styryl triazine.

Further suitable free radical photoinitiators include the ionic dye-counter ion compounds, which are capable of absorbing actinic rays and producing free radicals, which can initiate the polymerization of the acrylates. *See*, for example, published European Patent Application 223587, and U.S. Patents 4,751,102, 4,772,530 and 4,772,541.

In one embodiment, the present compositions comprise, relative to the total weight of the composition, 0.1-15 wt% of one or more free radical photoinitiators, for instance 1-10 wt%.

It has surprisingly been found that a composition containing a compound having a polyether backbone shows excellent mechanical properties after cure of the composition. Examples of compounds having a polyether backbone, are polytetramethylenediol, glycidylethers of polytetramethylenediol, acrylates of polytetramethylenediol or polytetramethylenediol containing one or more polycarbonate groups. In one embodiment of the invention, the composition contains between 5 and 20 wt% of a compound having a polyether backbone.

### (E) Filler

The composition of the present invention comprises at least one filler having a mean average particle size of between 3 and 500 nanometer. Such fillers are known in the art from for example US 6,467,897 and WO 98/51747, the entire disclosure of which is hereby incorporated by reference. The filler preferably contains inorganic particles like for example metals (like for example steel, Au or Ag) or metal complexes like for example metal oxides, metal hydroxides, metal sulfides, metal halogen complexes, metal carbides, metal phosphates, inorganic salts (like for example CaCO₃), ceramics. Examples of metal oxides are ZnO, CdO, SiO₂, TiO₂, ZrO₂, CeO₂, SnO₂, MoO₃, WO₃, Al₂O₃, In₂O₃, La₂O₃, Fe₂O₃, CuO, Ta₂O₅, Sb₂O₃ or Sb₂O₅. Mixed oxides containing different metals may also be present. Preferably, the nanoparticles used in the present invention comprise particles selected from the group consisting of ZnO, SiO₂, TiO₂, ZrO₂, SnO₂, Al₂O₃, and mixtures thereof. The nanometer sized particles may also have an organic nature like for example carbon black, highly crosslinked/ core shell polymer nanoparticles, organically modified nanometer-size particles etc.

These types of fillers can be present in the form of a so called sol. Sols useful in the practice of the present invention may be prepared by methods well known in the art. Suitable sols also are commercially available. For example, colloidal silicas in aqueous solutions are commercially available under such trade designations as "LUDOX" (E.I. DuPont de Nemours and Co., Inc. Wilmington, Del.), "NYACOL" (Nyacol Co., Ashland, Ma.) and "NALCO" (Nalco Chemical Co., Oak Brook, IIL). Most of these commercially available sols tend to be basic, being stabilized by alkali such as sodium hydroxide, potassium hydroxide, or ammonium hydroxide. Additional examples of suitable colloidal silicas are described in U.S. Pat. No. 5,126,394.

The sols can be functionalized by reacting one or more appropriate surface-treatment agents with the inorganic oxide substrate particles in the sol.

Nanoparticles dispersed in radiation curable monomers like for example epoxy monomers are available from Hanse Chemie as "NANOPOX" materials.

The mean average size of the fillers is below 50 nm. The mean average particle size of the filler is determined with SANS (small angle neutron spectroscopy). The mean average particle size is defined as the peak of the particle size distribution graph derived from SANS.

The filler is generally present in an amount from 5-70 wt%. The filler content is based on the amount of (functionalized) particles. Any solvent or reactive monomer is not considered to be filler, but merely represents one of the components of the composition. Preferably, the amount of filler is ranging between 5 and 50 wt%, more preferably between 20 and 45 wt%.

### (F) Additional components

The compositions of the present invention may comprise additional components like for example hydroxy-functional components and additives.

### Hydroxy-functional components

Preliminarily, hydroxy-functional components are understood to be absent curable groups (such as, *e*.*g*., acrylate-, epoxy-, or oxetane groups) and to be not selected from the group consisting of photoinitiators.

The present compositions may comprise one or more hydroxy-functional components. Hydroxy-functional components may be helpful in further tailoring mechanical properties of the present compositions upon cure. Hydroxy-functional components include monols (hydroxy-functional components comprising one hydroxy group) and polyols (hydroxy-functional components comprising more than one hydroxy group).

Representative examples of hydroxy-functional components include alkanols, monoalkyl ethers of polyoxyalkyleneglycols, monoalkyl ethers of alkyleneglycols, alkylene and arylalkylene glycols, such as 1,2,4-butanetriol, 1,2,6-hexanetriol, 1,2,3-heptanetriol, 2,6-dimethyl-1,2,6-hexanetriol, (2R,3R)-(-)-2-benzyloxy-1,3,4-butanetriol, 1,2,3-hexanetriol, 1,2,3-butanetriol, 3-methyl-1,3,5-pentanetriol, 1,2,3-cyclohexanetriol, 1,3,5-cyclohexanetriol, 3,7,11,15-tetramethyl-1,2,3-hexadecanetriol, 2-hydroxymethyltetrahydropyran-3,4,5-triol, 2,2,4,4-tetramethyl-1,3-cyclobutanediol, 1,3-cyclopentanediol, trans-1,2-cyclooctanediol, 1,16-hexadecanediol, 3,6-dithia-1,8-octanediol, 2-butyne-1,4-diol, 1,3-propanediol, 1,4-butanediol, 1,5-pentanediol, 1,6-hexanediol, 1,7-heptanediol, 1,8-octanediol, 1,9-nonanediol, 1-phenyl-1,2-ethanediol, 1,2-cyclohexanediol, 1,5-decalindiol, 2,5-dimethyl-3-hexyne-2,5-diol, 2,7-dimethyl-3,5-octadiyne-2-7-diol, 2,3-butanediol, 1,4-cyclohexanedimethanol, polyoxyethylene and polyoxypropylene glycols and triols of molecular weights from about 200 to about 10,000, polytetramethylene glycols of varying molecular weight, poly(oxyethylene-oxybutylene) random or block copolymers, copolymers containing pendant hydroxy groups formed by hydrolysis or partial hydrolysis of vinyl acetate copolymers, polyvinylacetal resins containing pendant hydroxyl groups; hydroxy-functional (e.g. hydroxy-terminated) polyesters and hydroxy-functional (e.g. hydroxy-terminated) polylactones, aliphatic polycarbonate polyols (e.g. an aliphatic polycarbonate diol), hydroxy-functional (e.g. hydroxy-terminated) polyethers (e.g. polytetrahydrofuran polyols having a number average molecular weight in the range of 150-4000 g/mol, 150-1500g/mol, or 150-750 g/mol), and combinations thereof.

In one embodiment, the compositions are absent substantial amounts of hydroxy-functional components. The absence of substantial amounts of hydroxy-functional components may decrease the hygroscopicity of the compositions and/or articles obtained therewith. For instance, the compositions may comprise, relative to the total weight of the composition, less than 15 wt%, less than 10 wt%, less than 6 wt%, less than 4 wt%, less than 2 wt%, or about 0 wt% of hydroxy-functional components.

### Other components

Stabilizers are sometimes added to the compositions in order to prevent a viscosity build-up, for instance a viscosity build-up during usage in a solid imaging process. Preferred stabilizers include those described in U.S. Patent 5,665,792, the entire disclosure of which is hereby incorporated by reference. Such stabilizers are usually hydrocarbon carboxylic acid salts of group IA and IIA metals. Most preferred examples of these salts are sodium bicarbonate, potassium bicarbonate, and rubidium carbonate. Alternative stabilizers are polyvinylpyrrolidones and polyacrylonitriles. Other possible additives are dyes, including dyes that change color upon cure. Examples of color-changing dyes include COPIKEM 20 (3,3-bis (1-butyl -2-methyl-H-indol-3-yl) - 1-(3H)-isobenzofuranone), COPIKEM 5 (2'-di (phenylmethy) amino-6'-(diethylamino)spiro(isobenzofuran-1(3H),9'-(9H)xanthen)-3-one), COPIKEM 14 (a substituted phthalide), COPIKEM 7 (3-{(4-dimethylamino)-phenyl}-3 -(1-butyl-2-methylindol-3-yl) -6-dimethyamino) -1 (3H)-isobenzofuranone), and COPIKEM 37 (2-(2-octoxyphenyl)-4-(4-dimethylaminophenyl)-6-(phenyl)pyridine). If present, the amount of color-changing dyes in the compositions is, relative to the total weight of the composition, preferably at least 0.0001 wt%, for instance at least 0.0005 wt%. In one embodiment, the amount of dye is, relative to the total weight of the composition, less than 1 wt%, *e.g.* less than 0.1 wt%. Even further examples of additives include antioxidants, wetting agents, antifoaming agents, thickening agents, thixotropic agents, photosensitizers (e.g. n-ethyl carbazole, benzoperylene, 1,8-diphenyl-1,3,5,7-octatetraene, or 1,6-diphenyl-1,3,5-hexatriene).

In one embodiment of the invention the compositions preferably comprise a dispersant. Addition of a dispersant may yield parts that have an unexpectedly high tensile strength in combination with a high Young's modulus. Examples of such dispersants are nonionic, non-silicone non-alkoxylated comprising surfactants, like for example N-alkylpyrrolidones, such as N-octylpyrrolidone; alkoxylates, such as ethoxylates, like Neodol 25-9 (commercially available from Shell Chemical); mixtures of the diglycerides of stearic, palmitic and oleic acids linked to the choline ester of phosphotic acid, like for example lecithin; condensation products of hydroxy or amine functional organic compounds with alkylene oxides; tertiary phosphine oxides; long chain dialkyl sulfoxides; or polysiloxanes.

Examples of hydroxy or amine functional organic compounds for making condensation products with alkylene oxides are polyols having 3 to about 20 carbon atoms, (C₈-C₁₈) fatty acid (C₁-C₈) alkanol amides like fatty acid ethanol amides, fatty alcohols, alkylphenols or diamines having 2 to 5 carbon atoms. Such compounds are reacted with alkylene oxides like ethylene oxide, propylene oxide or mixtures thereof. The reaction may take place in a molar ratio of hydroxy or amine containing organic compound to alkyleneoxide of for example 1:2 to 1:65. The condensation products typically have a weight average molecular weight of about 500 to about 10,000, and they may be branched, cyclic, linear, and either homopolymers, copolymers or terpolymers.

Examples of siloxanes are functionalized or non-functionalized siloxanes. Examples of siloxanes are compounds represented by the formula, 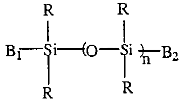 wherein each R is independently a substituted or unsubstituted linear, branched or cyclic C 1-10 alkyl, C 1-10 alkoxy, substituted or unsubstituted aryl, aryloxy, trihaloalkyl, cyanoalkyl or vinyl group, B₁ and/or B₂ is a hydrogen, siloxy group, vinyl, silanol, alkoxy, amine, epoxy, hydroxy, (meth)acrylate, mercapto or solvent phobic groups such as lipophilic or hydrophilic (e.g., anionic, cationic) groups and wherein n is an integer from about 1 to about 10,000, preferably from about 1 to about 100.

In general, the functionalized siloxane is a compound having a molecular weight ranging from about 300 to about 20,000. Such compounds are commercially available from for example the General Electric Company or from Goldschmidt, Inc. The preferred functionalized siloxane is an amine functionalized siloxane wherein the functionalization is preferably terminal to the siloxane.

The organosiloxanes are often sold under the name Silwet by Witco Corporation. Such surfactants typically have an average weight molecular weight of about 350 to about 15,000, are hydrogen or C₁-C₄ alkyl capped and may be hydrolyzable or non-hydrolyzable. Preferred organosiloxanes include those sold under the name of Silwet L-77, L-7602, L-7604 and L-7605, all of which are polyalkylene oxide modified dialkyl polysiloxanes.

Examples of suitable anionic dispersants are: (C₈-C₁₆) alkylbenzene sulfonates, (C₈-C₁₆) alkane sulfonates, (C₈-C₁₈) α-olefin sulfonates, α-sulfo (C₈-C₁₆) fatty acid methyl esters, (C₈-C₁₆) fatty alcohol sulfates, mono- and di- alkyl sulfosuccinates with each alkyl independently being a (C₈-C₁₆) alkyl group, alkyl ether sulfates, (C8-C16) salts of carboxylic acids and isethionates having a fatty chain of about 8 to about 18 carbons, for example sodium diethylhexyl sulfosuccinate, sodium methyl benzene sulfonate, sodium bis(2-ethylhexyl) sulfosuccinate [like Aerosol OT or AOT]

Preferably, the dispersant is a compound selected from organosiloxanes, functionalised organosiloxanes, alkyl-substituted pyrrolidones, polyoxyalkylene ethers, ethyleneoxide propylenenoxide block copolymers.

Examples of commercial dispersants that are suitable for the present invention are for example cyclic organo-silicones: SF1204, SF1256, SF1328, SF1202 (decamethyl-cyclopentasiloxane(pentamer)), SF1258, SF1528, Dow Corning 245 fluids, Dow Corning 246 fluids, dodecamethyl-cyclo-hexasiloxane (heximer), SF1173; copolymers of a polydimethylsiloxane and a polyoxyalkylene oxide SF1488, SF1288; linear silicon comprising oligomers Dow Corning 200 (R) fluids; Silwet L-7200, Silwet L-7600, Silwet L-7602, Silwet L-7605, Silwet L-7608, Silwet L-7622; nonionic surfactants Triton X-100, Igepal CO-630, PVP series, Airvol 125, Airvol 305, Airvol 502 and Airvol 205; organic polyethers Surfynol 420, Surfynol 440, Surfynol 465; Solsperse 41000.

Preferred commercial dispersants are SF1173 (from GE Silicones); organic polyether like Surfynol 420, Surfynol 440, Surfynol 465 (from Air Products Inc); Silwet L-7200, Silwet L-7600, Silwet L-7602, Silwet L-7605, Silwet L-7608, Silwet L-7622 (from Witco) and non-ionic surfactants Triton X-100 (from Dow Chemicals), Igepal CO-630 (from Rhodia), PVP series (from ISP Technologies) and Solsperse 41000 (from Avecia).

The amount of dispersant ranges from 0 to 5 wt%. More preferably, the amount of dispersant is between 0.1 and 2 wt%.

The present compositions, after full cure, preferably have an elongation at break of at least 0.5%, for instance at least 1.0%, at least 2 %, at least 3%, or at least 3.5%. The elongation at break is generally below 50%.

The physical condition of the present compositions may vary and can be, for instance, a liquid, a gel, a paste, or a solid. If the composition is a liquid, it preferably has a viscosity, at 30°C, of less than 1000 mPas, for instance less than 750 mPas, less than 650 mPas, less than 550 mPas, less than 450 mPas, or less than 350 mPas.

The present compositions, after full cure, preferably have a tensile strength of at least 35 MPa, for instance at least 40 MPa, at least 45 MPa, at least 50 MPa, at least 60 MPa, or at least 70 MPa.

The present compositions, after full cure, preferably have a Young's modulus of at least 1500 MPa, for instance at least 2000 MPa, at least 2500 MPa, at least 2750 MPa, or at least 3000 Mpa, wherein the Young's modulus is measured on a thin strip as disclosed in the experimental part.

The present compositions , after full cure, preferably have a Young's modulus of at least 2500 MPa, at least 3000 Mpa, preferably at least 4000 Mpa, more preferably at least 4500 MPa when measured on a tensile bar ("dogbone") having the dimensions of 15 cm length, 1 cm height and 1 cm width (narrowed portion). In general the Young's modulus is below 10 GPa.

### Applications

The present compositions may be used, for instance, as coating compositions or as compositions for preparing a three dimensional object by rapid prototyping. The compositions may be cured by heat or any suitable form of radiation, *e.g.* electron beam radiation or actinic radiation, or mixtures thereof. For instance, the composition may first be cured to a certain extent by radiation and subsequently be post-cured by heat.

Rapid prototyping, sometimes also referred to as "solid imaging" or "stereolithography", concerns the imagewise curing of successive thin layers of a curable composition to form a three-dimensional object. *See, e*.*g*., U.S. Patents 4,987,044; 5,014,207; 5,474,719; 5,476,748; and 5,707,780. A rapid prototyping process may for instance be described as:
(1) coating a layer of a composition onto a surface;
(2) exposing said layer imagewise to actinic radiation to form an imaged cross-section;
(3) coating a further layer of the composition onto said imaged cross-section;
(4) exposing said further layer imagewise to actinic radiation to form an additional imaged cross-section;
(5) repeating steps (3) and (4) a sufficient number of times in order to build up a three-dimensional article;
(6) optionally, post-curing the three-dimensional article.

The present invention also relates to the use of a composition as defined in the claims for making a three dimensional article having, after full cure, an elongation at break of at least 1.0%, and a tensile strength of at least 40 MPa, preferably of at least 50 MPa. Preferable the three dimensional article has also a Young's modulus of at least 2000 MPa, preferably of at least 2500 Mpa, preferably at least 3000 Mpa, at least 3500 MPa or at least 4000 Mpa.

The following examples are given as particular embodiments of the invention and to demonstrate the practice and advantages thereof. It is to be understood that the examples are given by way of illustration and are not intended to limit the specification or the claims that follow in any manner.

### EXAMPLES

### TEST METHODS

### (a') Tensile Strength, Young's modulus, Elongation at Break and Elongation at Yield

Tensile data was obtained by testing 10 mils film. At least 20 grams of composition was poured into a 100 mm diameter petri-dish and allowed to equilibrate to approximately 30°C and 30% RH. The samples were then scanned in a line-by-line fashion using a focused laser beam of approximately 100-160 mW, with an exposure (E10) between 30-300 mJ/cm². The laser, a frequency tripled YAG laser, had an output wavelength of 354.7 nm and was pulsed at 80 KHz. The exposures were made in a rectangle pattern approximately 76.2 mm long, 12.7mm wide and 0.254 mm thickness. Each strip was allowed to float on the surface of the petri-dish for approximately 15 minutes. Then the films were removed from the petridish, washed with tri(propyleneglycol) methyl ether ("TPM") and isopropanol, and placed in a post-curing apparatus ("PCA" sold by 3-D Systems, 10 bulb unit using Phillips TLK/05 40W bulbs). In the PCA, the film was post-cured 15 minutes of UV radiation at room temperature on each side. A film thickness and width measurement were taken using Mitutoyo NTO25-8"C spring loaded Absolute Digimatic calipers. The procedure of rapid prototyping a composition and post-curing a composition in the manner just described is understood herein to result in fully cured samples. The tensile tests to determine tensile strength, Young's modulus, elongation at break and elongation at yield were run immediately (this is within two hours) after preparation of the film (In accordance with ASTM D638, which is hereby incorporated in its entirety by reference, except that no provision was made for controlling the room temperature and humidity, the size of the bars were different and the bars were not equilibrated for 2 days). The reported data is the average of five measurements.

### (a") Tensile Strength, Young's modulus, Elongation at Break and Elongation at Yield; measured on tensile bars.

Tensile properties of all experiments have been performed on the thin strips as disclosed above. Examples 2.1-2.8 have also been tested as tensile bars, which gives slightly different mechanical properties as far as tensile strength and elongation at break is concerned, but larger deviations as far as Young's modulus is concerned. By way of example, both sets of data are summarized in table 2 (examples 2.1-2.8). The mechanical data in all examples and comparative experiments relating to thin strips can be compared to eachother. A conversion factor of 1,85 can be used to convert Young's modulus values of thin strips to Young's modulus values of tensile bars.

The tensile bars of examples 2.1-2.8 have been made and measured according to the following method: Tensile data was obtained by testing tensile bars ("dogbones") made by first consecutively imaging 150µm thick layers of the composition to be tested in a rapid prototyping machine. Each cross-sectional layer of the tensile bar was given exposure sufficient to polymerize the composition at a 250 µm depth, providing approximately 100 µm of overcure or engagement cure to assure adhesion to the previously coated and exposed layer. The layers were exposed with a laser emitting in the ultraviolet (UV) region at 354.7 nm. The resulting tensile bars/dogbones were approximately 150 mm long and had a cross-section in the narrowed portion of approximately 0.625cm x 0.625cm (1/4 inch). After preparation of the tensile bar in the rapid prototyping machine, the tensile bar was removed from the machine, washed with tri(propyleneglycol) methyl ether ("TPM") and isopropanol, and placed in a post-curing apparatus ("PCA" sold by 3-D Systems, 10 bulb unit using Phillips TLK/05 40W bulbs). In the PCA, the tensile bar was post-cured first by subjecting it to 60 minutes of UV radiation at room temperature. After these 60 minutes, the UV radiation was stopped and the tensile bar was subjected to 160°C for two hours. The procedure of rapid prototyping a composition and post-curing a composition in the manner just described is understood herein to result in fully cured samples. The tensile tests to determine tensile strength, Young's modulus, and elongation at break were run one day after preparation of the tensile bar and in accordance with ASTM D638, which is hereby incorporated in its entirety by reference, except that no provision was made for controlling the room temperature and humidity and the bars were not equilibrated for 2 days. The reported data is the average of three measurements.

### (b) E10, Dₚ, and E_{c}

The photoproperties E_{c} (mJ/cm²), Dₚ (µm), and E10 (mJ/cm²) represent the photoresponse (in this case thickness of layer formed) of a particular formulation to exposure by a single wavelength or range of wavelengths. In the instant Examples and Comparative experiments, at least 20 grams of composition was poured into a 100 mm diameter petri-dish and allowed to equilibrate to approximately 30°C and 30% RH. The samples were then scanned in a line-by-line fashion using a focused laser beam of approximately 100-140 mW. The laser, a frequency tripled YAG laser, had an output wavelength of 354.7 nm and was pulsed at 80 KHz. The exposures were made in a square pattern approximately 20 mm by 20 mm. Six individual exposures were made at near constant laser power but at various scan speeds. The parallel scan lines making up each exposure were drawn approximately 50 µm apart. Based upon knowledge of the diameter of the focused beam at the liquid surface, the scan speed, the laser power, and the scan spacing, the summation of exposure mJ/cm² was calculated. Each square was allowed to float on the surface of the petri-dish for approximately 15 minutes. Then the squares were blotted and a thickness measurement was taken using Mitutoyo NTO25-8°C spring loaded Absolute Digimatic calipers. When the natural log of the exposures is plotted against the measured thickness a least squares fit line can be drawn. The Dₚ (µm) is the slope of the least squares fit line. The E_{c} (mJ/cm²) is the X-axis crossing point (Y=0) of the line. And the E10 is the energy necessary to produce a layer approximately 10 mils (254 µm) thick. In general, the lower the E10 number, the faster the photospeed of the composition.

**Table 1: Glossary**

| **Commercial Name (Supplier)** | **Description** |
|---|---|
| EPON 825 ( Resolution Performance Products) | bisphenol A diglycidyl ether (aromatic epoxy) |
| EPICLON N-740 (Dainippon Ink & Chemical) | phenol epoxy novolac (aromatic epoxy) |
| HELOXY 64 (Resolution Performance Products) | nonylphenyl glycidyl ether (aromatic epoxy) |
| UVACURE 1500 (UCB Radcure) | 3,4-epoxy cyclohexyl methyl-3,4-epoxy cyclohexyl carboxylate (aliphatic epoxy) |
| UVR 6000 (Dow Chemical) | 3-ethyl-3-hydroxymethyl-oxetane (oxetane) |
| SR-399 (Sartomer) | monohydroxy dipentaerythritol pentaacrylate |
| IRGACURE 184 (Ciba Geigy) | 1-hydroxycyclohexyl phenyl ketone |
| DAROCURE 1173 (Ciba Geigy) | 2-hydroxy-2-methyl-1-phenyl-1-propanone |
| CPI-6976 (Aceto) | mixture of triarysulfonium hexafluoroantimonate salts |
| SILWET L-7600 (OSI Specialities) | Surfactant |
| BYK-A-501 (BYK-Chemie) | Defoamer |
| PVP (Aldrich) | stabilizer (polyvinylpyrolidone, Mw ca. 10,000) |
| Ebecryl 3700 (UCB Chemicals) | Acrylated ester of Bisphenol-A based epoxy |
| DPHA (Sartomer) | reaction product of dipentaerythritol and acrylic acid (dipentaerythritol hexaacrylate) |
| Grilonit F713 (EMS-PRIMID) | Polytetrahydrofurandiglycidylether |
| SR 9003(Sartomer) | Propoxylated Neopentyl Glycol Diacrylate |
| Heloxy 67 (Resolution Performance Products) | 1,4-butanediol diglycidyl ether |
| SR 295(Sartomer) | Pentaerythritol Tetraacrylate Esters |
| SR 351 (Sartomer) | trimethylolpropane triacrylate |
| Oxt 211 (Toagosei Co. Ltd) | 3-Ethyl-3-phenoxymethyl-oxetane |
| OXT 212 (Toagosei Co. Ltd) | 3-Ethyl-3-[(2-ethylhexyloxy)methyl]oxetane |
| Nanopox XP 22/0543 (hanse chemie) | 50% silica nanoparticle filled bisphenol A diglycidyl ether (aromatic epoxy) |
| Nanopox XP 22/0316(hanse chemie) | 50% silica nanoparticle filled in 3,4-epoxy cyclohexyl methyl-3,4-epoxy cyclohexyl carboxylate (aliphatic epoxy) |
| Nanopox XP 22/0540(hanse chemie) | 60% silica nanoparticle filled bisphenol F diglycidyl ether (aromatic epoxy) |
| Nanopox XP 22/0531 (hanse chemie) | 50% silica nanoparticle filled bisphenol F diglycidyl ether (aromatic epoxy) |
| Triton X-100 (Dow chemicals) | polyoxyethylene octyl phenyl ether |
| Airvol 305 (Air Products, Inc.) | polyvinyl alcohol |
| Pluronic L35 (BASF) | ethylene oxide propylene oxide copolymer |
| Pluronic 10R-5 (BASF) | ethylene oxide propylene oxide copolymer |
| Igapol AL CO-630 (Rhodia) | nonyl phenol ethoxylate |
| p-methoxyphenol (Aldrich) | p-methoxyphenol |
| Vinyltrimethoxysilane (Gelest, Inc.) | Vinyltrimethoxysilane |

Examples 1.9, 2.7-2.9, 2.12 and the examples specified on page 25 are reference examples.

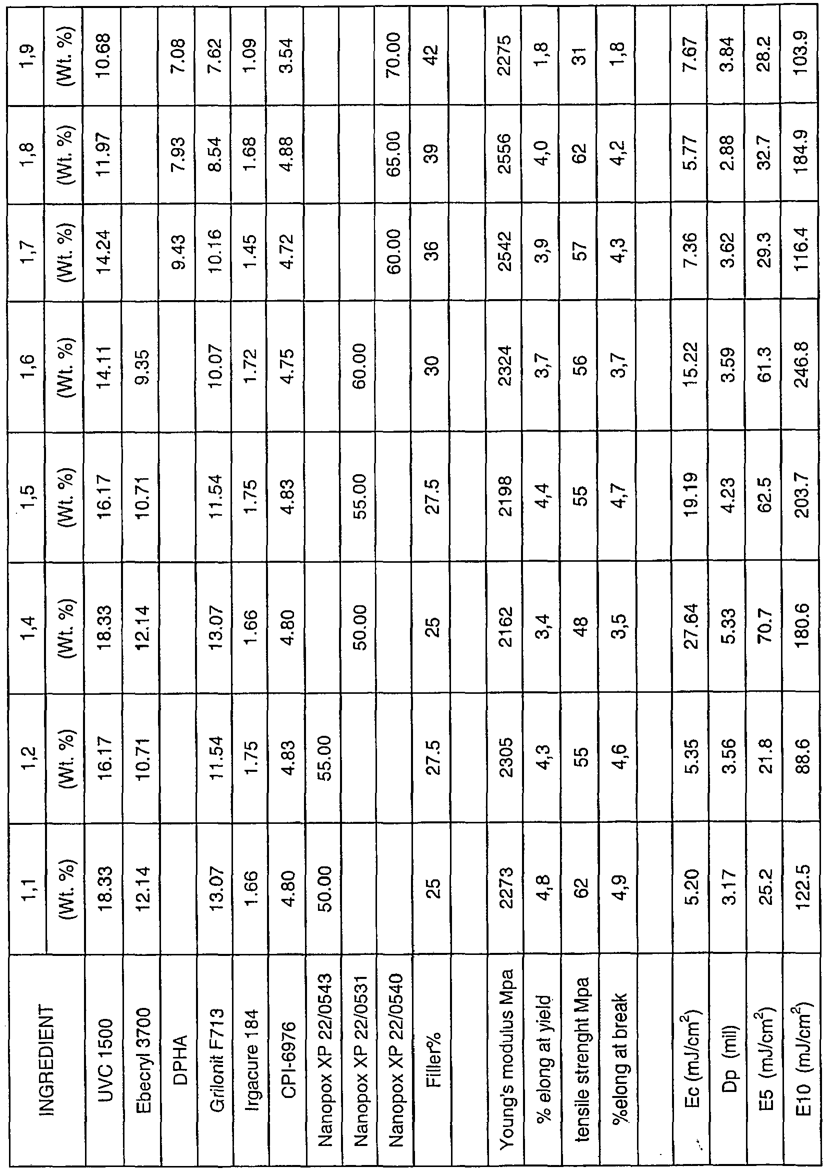

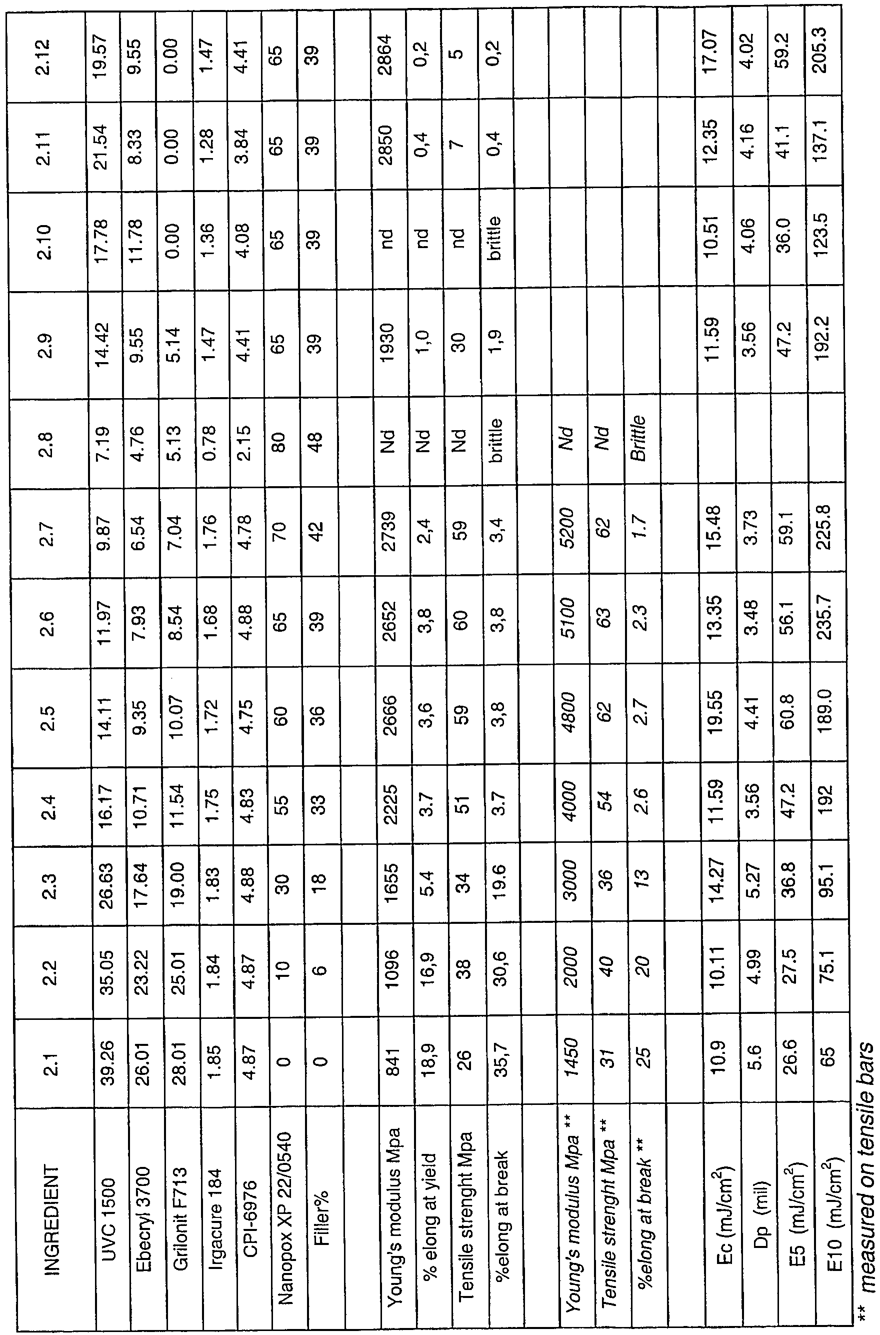

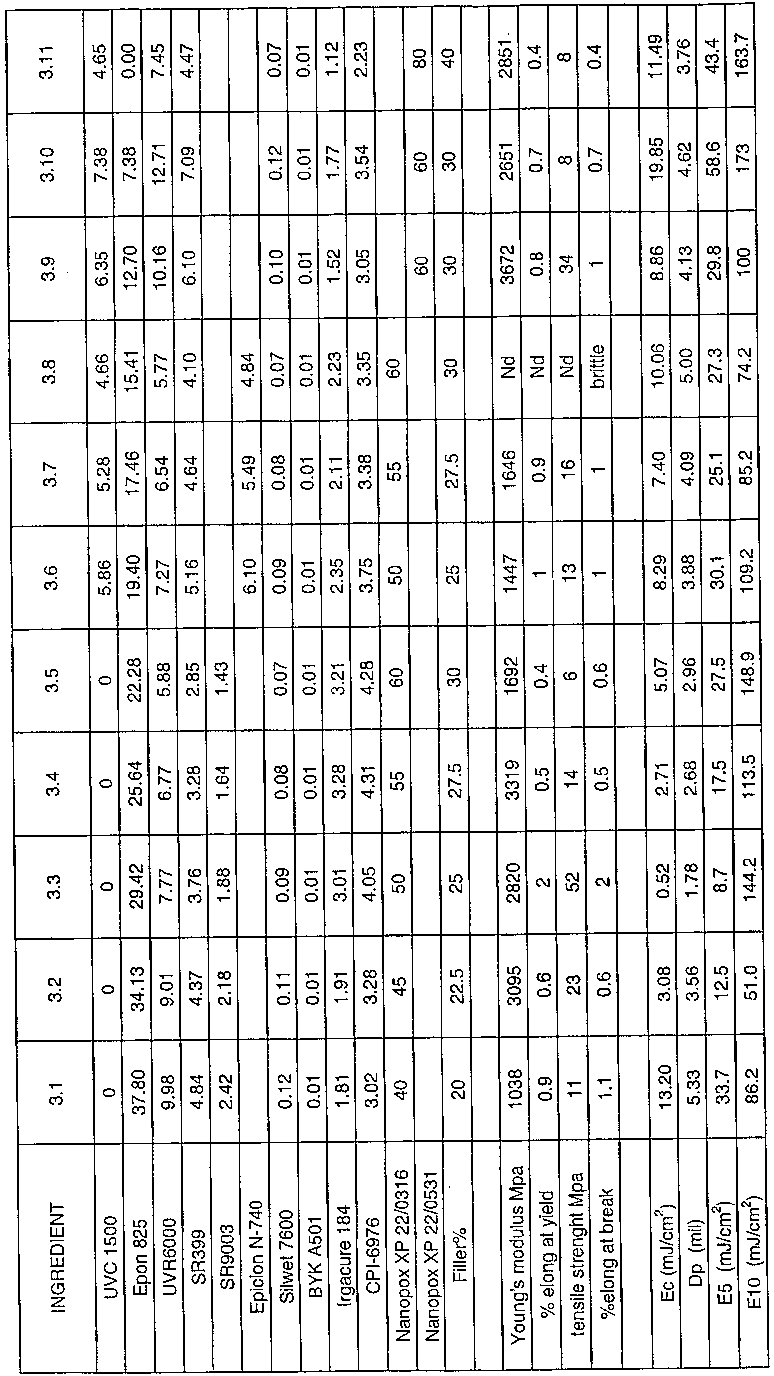

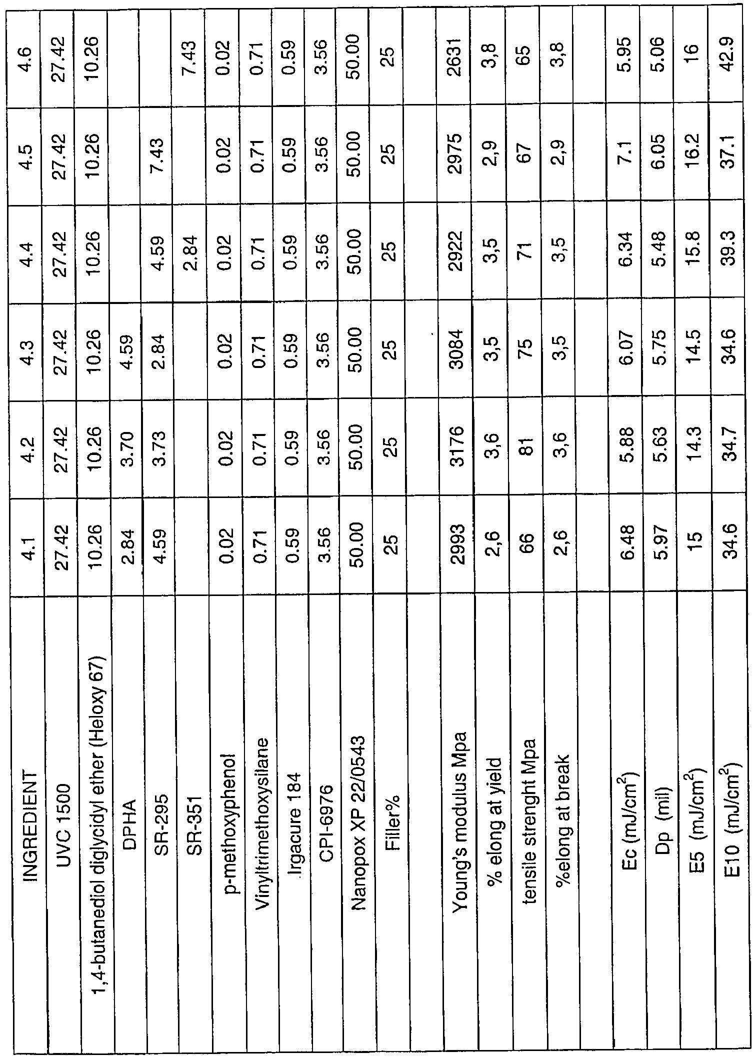

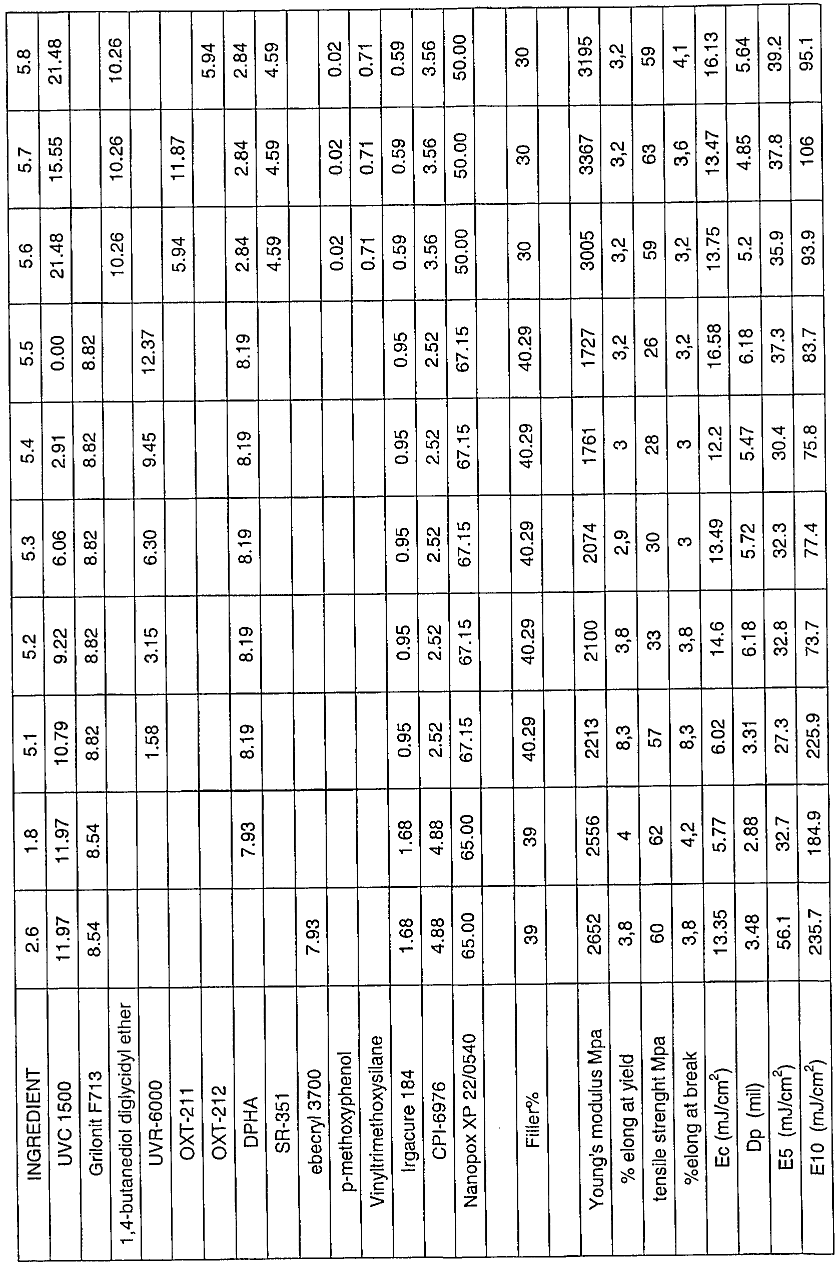

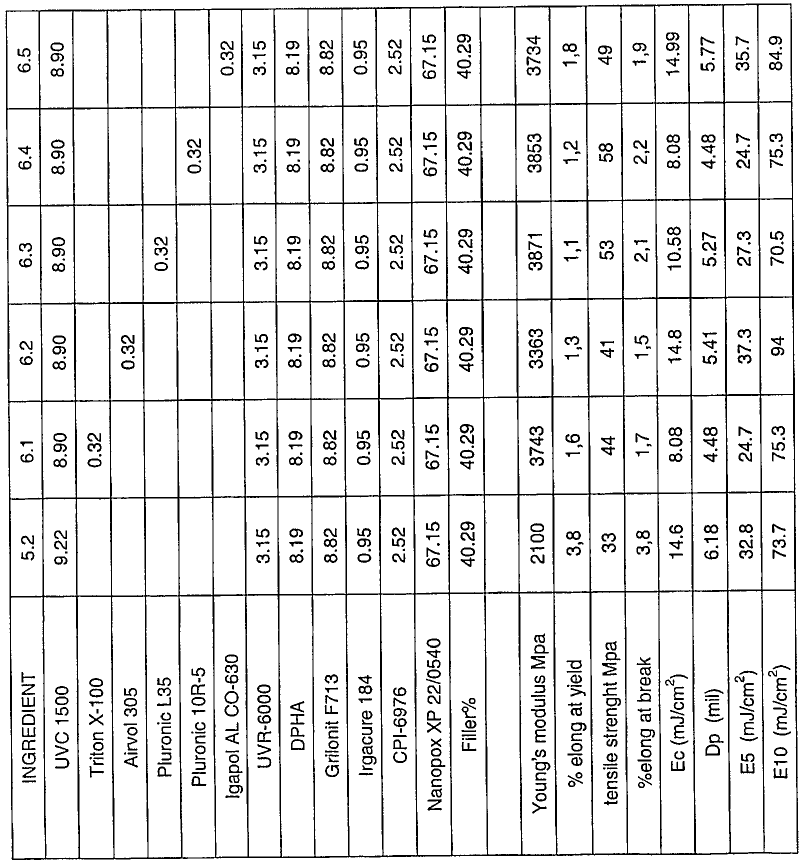

## Claims

1. A radiation curable composition comprising
a 10-90 wt% of a cationically polymerizable compound, said polymerizable compound comprising at least an aromatic epoxy-functional and an aliphatic epoxy-functional component
b 0.1-10 wt% of a cationic photoinitiator
c 1-40 wt% of a radically polymerizable compound
d 0.1-10 wt% of a radical photoinitiator and
e 5-50 wt% of a filler having a mean average particle size of at least 3 nm and below 50 nm,
wherein said composition comprises at least 20 wt.%, relative to the total weight of the composition, of one or more aliphatic epoxies.

2. The composition according to claim 1, wherein the amount of filler is ranging between 20 and 45 wt%.

3. The composition according to claim 1 or 2, wherein the cationically polymerizable compound contains epoxy-functional components and/or oxetane-functional components.

4. The composition according to any one of claims 1-3, wherein the composition comprises one or more mono or poly glycidylethers of aliphatic alcohols, aliphatic polyols, polyesterpolyols or polyetherpolyols.

5. The composition according to any one of claims 1-4, wherein the composition contains between 5 and 20 wt% of mono or poly glycidyl ethers of an aliphatic alcohol, aliphatic polyols, polyesterpolyol or polyetherpolyol.

6. The composition according to any one of claims 1-5, wherein the radically polymerizable compound contains one or more (meth)acrylate groups, preferably the radically polymerizable compound comprises one or more components having at least 3 (meth)acrylate groups.

7. The composition according to any one of the claims 1-6, wherein a component is present having a polyether backbone, preferably selected from the group consisting of polytetramethylenediol, glycidylethers of polytetramethylenediol, acrylates of polytetramethylenediol or polytetramethylenediol containing one or more polycarbonate groups.

8. The composition according to claim 7, wherein the compound having a polyether backbone is present in an amount ranging from 5 to 20 wt%.

9. The composition according to claim 1, wherein the composition comprises a dispersant.

10. The composition according to claim 9, wherein the dispersant is a compound selected from the group consisting of organosiloxanes, functionalised organosiloxanes, alkyl-substituted pyrrolidones, polyoxyalkylene ethers, ethyleneoxide propylenenoxide block copolymers.

11. The composition according to claim 9 or 10, wherein the amount of dispersant is between 0.1 and 2 wt%.

12. A rapid prototyping process comprising the steps:
(1) coating a layer of a composition onto a surface;
(2) exposing said layer imagewise to actinic radiation to form an imaged cross-section;
(3) coating a further layer of the composition onto said imaged cross-section;
(4) exposing said further layer imagewise to actinic radiation to form an additional imaged cross-section;
(5) repeating steps (3) and (4) a sufficient number of times in order to build up a three-dimensional article;
(6) optionally, post-curing the three-dimensional article,
wherein a composition is used as defined in any one of the claims 1-11.

## Patentansprüche

1. Strahlungshärtbare Zusammensetzung, umfassend
a 10-90 Gew.-% einer kationisch polymerisierbaren Verbindung, wobei die polymerisierbare Verbindung mindestens eine aromatische Epoxid-funktionelle und eine aliphatische Epoxid-funktionelle Komponente umfasst
b 0,1-10 Gew.-% eines kationischen Photoinitiators
c 1-40 Gew.% einer radikalisch polymerisierbaren Verbindung
d 0,1-10 Gew.-% eines radikalischen Photoinitiators und
e 5-50 Gew.-% eines Füllstoffes mit einer mittleren durchschnittlichen Partikelgröße von mindestens 3 nm und unter 50 nm,
wobei die Zusammensetzung mindestens 20 Gew.-%, bezogen auf das Gesamtgewicht der Zusammensetzung, von einem oder mehreren aliphatischen Epoxiden umfasst.

2. Zusammensetzung nach Anspruch 1, wobei die Menge an Füllstoff im Bereich zwischen 20 und 45 Gew.-% liegt.

3. Zusammensetzung nach Anspruch 1 oder 2, wobei die kationisch polymerisierbare Verbindung Epoxid-funktionelle Komponenten und/oder Oxetan-funktionelle Komponenten enthält.

4. Zusammensetzung nach einem der Ansprüche 1-3, wobei die Zusammensetzung einen oder mehrere Mono- oder Polyglycidether von aliphatischen Alkoholen, aliphatischen Polyolen, Polyesterpolyolen oder Polyetherpolyolen umfasst.

5. Zusammensetzung nach einem der Ansprüche 1-4, wobei die Zusammensetzung zwischen 5 und 20 Gew.-% von Mono- oder Polyglycidylethern eines aliphatischen Alkohols, aliphatischen Polyolen, eines Polyesterpolyols oder eines Polyetherpolyols enthält.

6. Zusammensetzung nach einem der Ansprüche 1-5, wobei die radikalisch polymerisierbare Verbindung eine oder mehrere (Meth)acrylatgruppen enthält, wobei bevorzugt die radikalisch polymerisierbare Verbindung eine oder mehrere Komponenten mit mindestens 3 (Meth)acrylatgruppen umfasst.

7. Zusammensetzung nach einem der Ansprüche 1-6, wobei eine Komponente anwesend ist, die ein Polyether-Rückgrat hat, bevorzugt ausgewählt aus der Gruppe bestehend aus Polytetramethylendiol, Glycidylethern von Polytetramethylendiol, Acrylaten von Polytetramethylendiol oder Polytetramethylendiol, das eine oder mehrere Polycarbonatgruppen enthält.

8. Zusammensetzung nach Anspruch 7, wobei die Verbindung mit einem Polyether- Rückgrat in einer Menge i Bereich von 5 bis 20 Gew.-% anwesend ist.

9. Zusammensetzung nach Anspruch 1, wobei die Zusammensetzung ein Dispergiermittel umfasst.

10. Zusammensetzung nach Anspruch 9, wobei das Dispergiermittel eine Verbindung ist, ausgewählt aus der Gruppe bestehend aus Organosiloxanen, funktionalisierten Organosiloxanen, Alkyl-substituierten Pyrrolidonen, Polyoxyalkylen-Ethern, Ethylenoxid-Propylenoxid-Block-Copolymeren.

11. Zusammensetzung nach Anspruch 9 oder 10, wobei die Menge an Dispergiermittel zwischen 0,1 und 2 Gew.-% liegt.

12. Schnelles Prototyping Verfahren, umfassend die Schritte:
(1) Auftragen einer Schicht einer Zusammensetzung auf eine Oberfläche;
(2) Aussetzen der Schicht bildweiser aktinischer Bestrahlung, um einen belichteten Querschnitt zu erhalten;
(3) Auftragen einer weiteren Schicht der Zusammensetzung auf den belichteten Querschnitt;
(4) Aussetzen der weiteren Schicht bildweiser aktinischer Bestrahlung, um einen zusätzlichen belichteten Querschnitt zu bilden;
(5) Wiederholen der Schritte (3) und (4) in ausreichender Anzahl von Malen, um einen dreidimensionalen Gegenstand aufzubauen;
(6) optional Nachhärten des dreidimensionalen Gegenstands,
wobei eine Zusammensetzung wie in einem der Ansprüche 1-11 definiert verwendet wird.

## Revendications

1. Composition durcissable par rayonnement comprenant :
a. de 10 à 90 % en poids d'un composé cationiquement polymérisable, ledit composé cationiquement polymérisable comprenant au moins un composant à fonctionnalité époxy aromatique et un composant à fonctionnalité époxy aliphatique
b. de 0,1 à 10 % en poids d'un photoinitiateur cationique
c. de 1 à 40 % en poids d'un composé polymérisable par voie radicalaire
d. de 0,1 à 10 % en poids d'un photoinitiateur radicalaire et
e. de 5 à 50 % en poids d'une charge ayant une granulométrie moyenne d'au moins 3 nm et inférieure à 50 nm,
dans laquelle ladite composition comprend au moins 20 % en poids, par rapport au poids total de la composition, d'un ou plusieurs époxy aliphatiques.

2. Composition selon la revendication 1, dans laquelle la quantité de charge est comprise dans la plage allant de 20 à 45 % en poids.

3. Composition selon la revendication 1 ou 2, dans laquelle le composé cationiquement polymérisable contient des composants à fonctionnalité époxy et/ou des composants à fonctionnalité oxétane.

4. Composition selon l'une quelconque des revendications 1 à 3, dans laquelle la composition comprend un ou plusieurs éthers mono- ou polyglycidyliques d'alcools aliphatiques, polyols aliphatiques, polyesterpolyols ou polyétherpolyols.

5. Composition selon l'une quelconque des revendications 1 à 4, dans laquelle la composition contient entre 5 et 20 % en poids d'éthers mono- ou polyglycidyliques d'un alcool aliphatique, polyol aliphatique, polyesterpolyol ou polyétherpolyol.

6. Composition selon l'une quelconque des revendications 1 à 5, dans laquelle le composé polymérisable par voie radicalaire contient un ou plusieurs groupes (méth)acrylate, de préférence le composé polymérisable par voie radicalaire comprend un ou plusieurs composants ayant au moins 3 groupes (méth)acrylate.

7. Composition selon l'une quelconque des revendications 1 à 6, dans laquelle un composant est présent ayant un squelette de polyéther, de préférence choisi dans le groupe constitué par un polytétraméthylènediol, les éthers glycidyliques de polytétraméthylènediol, les acrylates de polytétraméthylènediol ou un polytétraméthylènediol contenant un ou plusieurs groupes polycarbonate.

8. Composition selon la revendication 7, dans laquelle le composé ayant un squelette de polyéther est présent en une quantité comprise dans la plage allant de 5 à 20 % en poids.

9. Composition selon la revendication 1, dans laquelle la composition comprend un dispersant.

10. Composition selon la revendication 9, dans laquelle le dispersant est un composé choisi dans le groupe constitué par les organosiloxanes, les organosiloxanes fonctionnalisés, les pyrrolidones à substitution alkyle, les éthers de polyoxyalkylène, les copolymères séquencés d'oxyde d'éthylène et d'oxyde de propylène.

11. Composition selon la revendication 9 ou 10, dans laquelle la quantité de dispersant est comprise entre 0,1 et 2 % en poids.

12. Procédé de prototypage rapide comprenant les étapes consistant à :
(1) revêtir une couche d'une composition sur une surface ;
(2) exposer ladite couche conformément à l'image à un rayonnement actinique pour former une section transversale imagée ;
(3) revêtir une autre couche de la composition sur ladite section transversale imagée ;
(4) exposer ladite autre couche conformément à l'image à un rayonnement actinique pour former une autre section transversale imagée ;
(5) répéter les étapes (3) et (4) un nombre suffisant de fois afin de construire un article tridimensionnel ;
(6) éventuellement post-durcir l'article tridimensionnel,
dans lequel une composition est utilisée telle que définie selon l'une quelconque des revendications 1 à 11.
